(19) Europäisches Patentamt
European Patent Office
Office européen des brevets

(11) **EP 1 151 507 B1**

(12) **FASCICULE DE BREVET EUROPEEN**

(45) Date de publication et mention
de la délivrance du brevet:
**23.04.2003 Bulletin 2003/17**

(51) Int Cl.⁷: **H01S 3/16**, H01S 5/34, H01S 5/183

(21) Numéro de dépôt: **00901721.1**

(22) Date de dépôt: **07.02.2000**

(86) Numéro de dépôt international:
**PCT/FR00/00279**

(87) Numéro de publication internationale:
**WO 00/048275 (17.08.2000 Gazette 2000/33)**

(54) **DISPOSITIF EMETTEUR DE LUMIERE, EN SILICIUM ET PROCEDE DE FABRICATION**

LICHTEMITTIERENDE VORRICHTUNG AUS SILIZIUM UND HERSTELLUNGSVERFAHREN

SILICON LIGHT-EMITTING DEVICE AND METHOD FOR THE PRODUCTION THEREOF

(84) Etats contractants désignés:
**DE GB IT**

(30) Priorité: **10.02.1999 FR 9901560**

(43) Date de publication de la demande:
**07.11.2001 Bulletin 2001/45**

(73) Titulaire: **COMMISSARIAT A L'ENERGIE ATOMIQUE**
**75752 Paris Cédex 15 (FR)**

(72) Inventeurs:
 • PAUTRAT, Jean-Louis
  **F-38100 Grenoble (FR)**
 • ULMER, Hélène
  **F-38610 Venon (FR)**
 • MAGNEA, Noel
  **F-38430 Moirans (FR)**
 • HADJI, Emmanuel
  **F-38600 Fontaine (FR)**

(74) Mandataire: **Weber, Etienne Nicolas et al**
**c/o Brevatome,**
**3, rue du Docteur Lancereaux**
**75008 Paris (FR)**

(56) Documents cités:
EP-A- 0 578 407    WO-A-96/25767
US-A- 5 107 538    US-A- 5 374 564
US-A- 5 563 979

• ENNEN H ET AL: "1.54- mu m electroluminescence of erbium-doped silicon grown by molecular beam epitaxy" APPLIED PHYSICS LETTERS, 15 FEB. 1985, USA, vol. 46, no. 4, pages 381-383, XP002137329 ISSN: 0003-6951
• REITTINGER A ET AL: "INFLUENCE OF THE ERBIUM AND OXYGEN CONTENT ON THE ELECTROLUMINESCENCE OF EPITAXIALLY GROWN ERBIUM-DOPED SILICON DIODES" APPLIED PHYSICS LETTERS, vol. 70, no. 18, 5 mai 1997 (1997-05-05), pages 2431-2433, XP000701346 ISSN: 0003-6951
• FUKATSU S ET AL: "CAVITY MODE LUMINESCENCE OF STRAINED SI1-XGEX/SI QUANTUM WELLS GROWN ON A BURIED-OXIDE SUBSTRATE" JOURNAL OF CRYSTAL GROWTH, vol. 150, no. 1/04, PART 02, 1 mai 1995 (1995-05-01), pages 1055-1059, XP000627835 ISSN: 0022-0248

## Description

Domaine technique

La présente invention concerne un dispositif émetteur et guide de lumière avec une région active à base de silicium, et des procédés de fabrication d'un tel dispositif.

On entend par région active une région du dispositif dans laquelle est générée et/ou guidée la lumière avant de quitter le dispositif.

L'invention trouve des applications dans la réalisation de composants optiques ou optoélectroniques tels que des diodes électroluminescentes, des lasers, et éventuellement des photodétecteurs.

Une application particulièrement avantageuse de l'invention, liée à l'utilisation de silicium pour la région active, est la fabrication de circuits intégrés combinant à la fois des composants électroniques et des composants optiques. Les composants électroniques sont en effet réalisés majoritairement à partir de silicium, en raison des qualités intrinsèques de ce matériau semi-conducteur, et en raison du grand développement des technologies relatives à sa mise en oeuvre.

Etat de la technique antérieure

Comme évoqué ci-dessus, le silicium est très largement utilisé dans la réalisation de composants ou de circuits intégrés électroniques à semi-conducteurs.

Cependant, dans certaines applications, dans lesquelles sont utilisés des composants destinés à l'émission de lumière, le silicium s'avère inadapté.

En effet, le silicium est un semi-conducteur à bande interdite indirecte et n'est pas adapté à la recombinaison rapide des porteurs, c'est-à-dire des paires électron-trou, avec production de lumière. Lorsque l'on met en présence les électrons et les trous, par exemple en polarisant en direct une jonction p-n formée dans le silicium, le temps moyen de leur recombinaison peut atteindre des durées de l'ordre de la microseconde ou plus. En fait, le phénomène de recombinaison des porteurs est dominé par d'autres processus plus rapides que la recombinaison radiative. Ces processus correspondent essentiellement à la recombinaison non radiative des porteurs sur des défauts et impuretés.

Les défauts et impuretés jouent un rôle important, même si leur concentration est faible. Les porteurs se déplacent dans le semi-conducteur sur une grande distance et leur probabilité de rencontrer un défaut ou une impureté est grande.

Ainsi, dans certains nombre d'applications, il s'avère indispensable de remplacer le silicium par un autre matériau semi-conducteur à bande interdite directe comme l'arséniure de gallium (GaAs), par exemple. A titre indicatif, pour ce semi-conducteur, le temps moyen de recombinaison des paires électron-trou est de l'ordre de la nanoseconde.

L'arséniure de gallium est cependant un matériau coûteux et plus complexe à mettre en oeuvre.

Dans un certain nombre de cas particuliers et dans des conditions d'utilisation particulières, le silicium a été proposé pour la réalisation de dispositifs d'émission ou de conduction de la lumière. Des exemples de telles utilisations du silicium sont suggérées notamment dans les documents (1) à (9) dont les références sont précisées à la fin de la présente description.

Les documents suggèrent des techniques permettant d'augmenter l'efficacité de l'émission de lumière par le silicium, toutefois, ces techniques ne sont généralement pas adaptées aux exigences de l'intégration des composants.

De façon plus particulière, les documents (6) et (7) décrivent des dispositifs d'émission de lumière réalisés sur un substrat de type silicium sur isolant (SOI - Silicon On Insulator) de plus en plus utilisé en micro-électronique. Cependant, les conditions de fonctionnement à basse température et le caractère isotrope de l'émission de lumière des dispositifs constituent également des obstacles à leur utilisation comme composants d'un circuit.

Les documents (8) et (9) décrivent respectivement un résonateur à phonons et des réalisations particulières de diodes au silicium dopées à l'erbium.

Exposé de l'invention

La présente invention a pour but de proposer un dispositif capable d'émettre mais aussi de guider la lumière, qui soit à base de silicium et qui soit susceptible d'être réalisé selon des techniques communes, propres à la micro-électronique.

Un but est également de proposer un tel dispositif pouvant être utilisé comme un composant individuel ou comme un composant intégré dans un circuit, en association avec d'autres composants optiques ou électroniques.

Un autre but est de proposer un tel dispositif avec un rendement d'émission de lumière amélioré et susceptible de fonctionner à température ambiante.

Un but est aussi de proposer des procédés de fabrication d'un dispositif conforme à l'invention.

Pour atteindre ces buts, l'invention a plus précisément pour objet un dispositif émetteur et guide de tel que défini par la revendication 1. Les revendications 2 à 15 indiquent des réalisations particulières du dispositif.

Le dispositif de l'invention présente à la fois l'avantage de confiner les porteurs dans une région limitée, la région active, de façon à réduire la probabilité de rencontre des porteurs avec des centres non radiatifs, et l'avantage d'offrir aux porteurs, dans cette région, des centres radiatifs à durée de vie courte.

On entend par durée de vie courte une durée de vie plus faible que la durée de vie liée à la probabilité de recombinaison non radiative sur des défauts ou impuretés de la région active.

La région active est, par exemple, un film mince et continu de silicium empilé entre les première et deuxième couches isolantes. Ce film est de préférence monocristallin, ce qui lui confère des qualités radiatives supérieures.

Selon une réalisation particulière du dispositif de l'invention, l'ensemble comprenant la région active et les couches d'isolant présente une épaisseur optique e telle que :

$$e = k \frac{\lambda}{2},$$

où k est un entier naturel.

Dans cette réalisation particulière, adaptée à un dispositif fonctionnant à une longueur d'onde λ donnée, la lumière est confinée dans la région active. Elle se propage dans le plan principal de cette région, notamment dans le cas où la région active est une couche mince de silicium, par réflexion totale sur les couches isolantes. Le plan principal est défini comme un plan de la région active sensiblement parallèle à celui des couches isolantes.

La réflexion totale est obtenue grâce à un saut d'indice approprié entre le matériau de la région active (Si) et celui utilisé pour les couches isolantes (par exemple SiO$_2$).

L'épaisseur optique e de la couche ou de la région active en silicium est adaptée à la longueur d'onde de travail λ de sorte que : $e = k \frac{\lambda}{2}$ où k est un nombre entier.

Selon une variante, la propagation peut également être prévue pour être perpendiculaire au plan principal. Dans ce cas, le dispositif peut comporter en outre des moyens de réflexion de la lumière comportant au moins un miroir disposé sur une face libre d'au moins l'une des première et deuxième couches d'isolant.

Plus précisément, les moyens de réflexion de la lumière peuvent comporter un premier miroir disposé sur la face libre de la première couche d'isolant et un deuxième miroir disposé sur la face libre de la deuxième couche d'isolant, les premier et deuxième miroirs présentant des coefficients de transmission différents.

Le miroir présentant le coefficient de transmission le plus élevé peut alors être utilisé comme un miroir de sortie de la lumière.

Par ailleurs, les premier et deuxième miroirs peuvent former avec la région active une cavité de type Fabry-Pérot.

Il convient de préciser que les moyens de réflexion ont également une fonction de guidage de la lumière.

Comme indiqué précédemment, la région active contient des centres radiatifs, c'est-à-dire des centres permettant la recombinaison radiative des porteurs.

Différents types de centres radiatifs peuvent être prévus et éventuellement combinés dans la région active.

Un premier type de centres radiatifs peut être constitué par des ions de terres rares, accompagnés éventuellement d'autres impuretés.

Les terres rares, telles que par exemple l'erbium, le praséodyme ou le néodyme sont des centres de recombinaison radiative efficaces. La longueur d'onde de la lumière émise est principalement déterminée par la nature de la terre rare et très peu par la matrice, c'est-à-dire ici le silicium. Les terres rares mentionnées ci-dessus sont particulièrement intéressantes car leur émission correspond aux longueurs d'onde utiles pour les télécommunications par fibre optique (1,3 et 1,54 micron). Le co-dopage avec d'autres impuretés telles que l'oxygène, le carbone, l'azote ou le fluor peut encore accroître de façon significative cette émission.

Un deuxième type de centres radiatifs peut être constitué par un puits quantique ou une succession de plusieurs puits quantiques formés par des couches minces de germanium ou d'alliage Si$_{1-x}$Ge$_x$ (avec 0<x≤1) ou SiGeC ou de tout autre composé adapté à la formation de puits quantiques. L'épaisseur des couches formant les puits peut être par exemple de l'ordre de 5 nm. De plus, l'épaisseur cumulée de ces couches est de préférence maintenue inférieure à une épaisseur critique correspondant à l'apparition de dislocations de désaccord de maille dans le silicium. Ainsi, la qualité cristalline de la région active reste très bonne. Les puits quantiques conduisent à une efficacité accrue de recombinaison radiative. De plus, une succession de puits et de barrières très minces, peut conduire à la formation d'une structure de bande semblable à une structure à bande interdite directe, avec une grande probabilité de recombinaison radiative. Les barrières de potentiel sont formées par le silicium entre les couches de germanium.

Un troisième type de centres radiatifs peut être constitué par des boîtes quantiques formées à partir d'un film de germanium ou de silicium-germanium, ou à partir d'autres éléments introduits dans le silicium.

En effet, du fait du désaccord de paramètre de maille entre le silicium et le germanium, le film de germanium, s'il excède une épaisseur de quelques monocouches se transforme naturellement en une succession d'îlots isolés répartis dans la région active, qui constituent les boîtes quantiques.

Ces îlots sont de 100 à 1000 fois plus efficaces que le germanium sous forme de couche massive pour l'émission de lumière. L'introduction de tels îlots dans le film de silicium permet donc de constituer un émetteur de lumière très efficace.

Les photons dans la région active peuvent être créés par "pompage" optique ou électrique.

Dans le premier cas, les moyens pour créer des photons dans la région active peuvent comporter une source additionnelle de lumière.

Dans le cas d'un pompage électrique, les moyens pour créer des photons dans la région active comportent une diode formée dans la région active.

Le dispositif de l'invention peut comporter une zone active unique, se présentant, par exemple, comme évoqué ci-dessus, sous la forme d'une couche continue de silicium.

Selon une variante, toutefois, le dispositif peut aussi comporter une pluralité de régions actives entre les première et deuxième couches isolantes et séparées entre elles par un matériau isolant.

Les régions actives peuvent être, par exemple, des îlots de silicium entourés d'oxyde de silicium. Les îlots présentent de préférence une dimension caractéristique comprise entre 100 et 200 nm. En particulier, il peut être avantageux d'avoir une dimension caractéristique sensiblement égale à l'épaisseur.

Les couches ou zones d'isolant qui délimitent ou entourent les zones actives ont essentiellement pour rôle de limiter le mouvement des porteurs qui se déplacent de façon prédominante sous l'effet de la diffusion, ou, selon le cas, sous l'effet d'un champ électrique.

Les couches ou zones d'isolant sont de préférence en un matériau avec une bande interdite large, de façon à opposer aux porteurs des barrières de potentiel élevées. Parmi ces matériaux isolants, on peut citer, par exemple, le SiC (carbure de silicium).

Comme beaucoup d'autres isolants, le carbure de silicium présente avec le silicium un désaccord de maille trop important pour envisager la croissance du silicium sur le SiC avec une bonne qualité cristalline.

Pour surmonter cette difficulté, l'invention a également pour objet un procédé de fabrication d'un dispositif tel que décrit précédemment. Ce procédé comporte le report, par collage moléculaire, d'une couche mince de silicium destinée à former la région active sur un support qui constitue ou comprend une première couche d'isolant. Le procédé est complété par le recouvrement de ladite couche de silicium par une deuxième couche d'isolant.

Le report par collage moléculaire permet d'associer au silicium des matériaux isolants présentant d'excellentes propriétés de barrière de potentiel, même si ces matériaux ne présentent pas de structure cristalline ou si ces matériaux présentent une structure cristalline incompatible avec la croissance de silicium.

La couche mince de silicium peut être reportée sur un support massif isolant en un matériau tel que, par exemple, les alliages SiC, ZnO, AlN ou BN.

Les techniques de collage moléculaire, bien connues en soi, ne sont pas décrites ici.

Selon une autre possibilité, la couche mince de silicium peut aussi être collée sur un support formé d'un substrat de silicium recouvert d'une couche superficielle en un matériau diélectrique usuel en micro-électronique, tel que $SiO_2$, $Si_3N_4$ ou le quartz.

Selon une mise en oeuvre particulière du procédé, le report de la couche mince comporte le collage moléculaire sur le support d'un bloc de silicium épais par une face de report, le bloc de silicium étant pourvu d'une zone de clivage préférentiel parallèle à la face de report et délimitant la couche mince, puis après le collage, le clivage dudit bloc pour en séparer la couche mince du bloc.

La zone de clivage peut être formée par exemple avant le report en implantant des ions appropriés, tels que des ions hydrogène à une profondeur déterminée dans le bloc de silicium pour y créer la zone de clivage préférentielle.

Selon une variante, le report de la couche mince peut comporter le collage sur le support d'une couche de silicium solidaire d'un substrat du support (par exemple en silicium massif) par l'intermédiaire d'une couche sacrificielle, puis la séparation de la couche mince de substrat par dissolution de la couche sacrificielle.

A titre d'exemple, la couche de silicium destinée à former la région active peut être formée par épitaxie sur le substrat de silicium qui a été préalablement recouvert d'une couche sacrificielle d'alliage GeSi.

La composition et l'épaisseur de la couche de GeSi sont choisies de préférence de façon à autoriser la croissance d'une couche de silicium de bonne qualité cristalline.

La couche de silicium peut encore être partiellement oxydée pour la recouvrir d'une couche d'oxyde.

Le substrat équipé de la couche de silicium est ensuite reporté sur le support, et l'alliage de SiGe est dissout pour détacher du substrat la couche de silicium formant la région active.

Selon encore une autre possibilité de réalisation du dispositif, le procédé peut aussi comporter la formation d'une couche d'oxyde enterrée dans un bloc de silicium, de façon à y délimiter une couche mince superficielle de silicium, la couche mince superficielle étant destinée à former la région active, puis le recouvrement de la couche mince par une couche d'oxyde.

D'autres caractéristiques et avantages de la présente invention ressortiront mieux de la description qui va suivre, en référence aux figures des dessins annexés. Cette description est donnée à titre purement illustratif et non limitatif.

Brève description des figures

- Les figures 1 et 2 sont des coupes schématiques partielles d'un dispositif électrooptique illustrant un aspect d'un procédé de réalisation d'une région active entre deux couches isolantes, conforme à l'invention.

- Les figures 3A , 3B, 4 et 5 sont des coupes schématiques partielles de dispositifs conformes à l'invention et illustrent différentes caractéristiques et réalisations possibles de la région active.

- Les figures 6 et 7 sont des coupes schématiques partielles de dispositifs conformes à l'invention et illustrent différentes possibilités de réalisation de moyens de guidage de la lumière.

- Les figures 8 et 9 sont des coupes schématiques de dispositifs conformes à l'invention illustrant différentes possibilités de réalisation de moyens de pompage.

Description détaillée de modes de mise en oeuvre de l'invention

Dans la description qui suit, des parties identiques, similaires ou équivalentes des différentes figures sont repérées avec les mêmes références numériques. Pour des raisons de commodité, les parties équivalentes ne sont toutefois pas représentées à la même échelle sur les différentes figures.

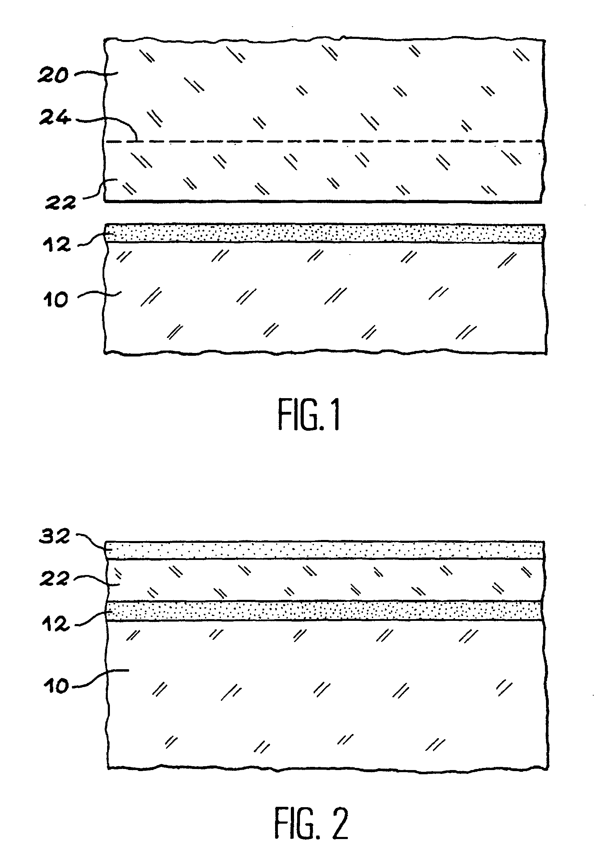

La référence 10 sur la figure 1 désigne un substrat de support en silicium sur lequel on souhaite réaliser un dispositif tel que décrit précédemment.

Le support 10 présente à sa surface une première couche 12 d'oxyde de silicium, utilisé ici comme isolant.

A titre de variante, l'ensemble formé par le support 10 et la première couche 12 pourrait être remplacé par un support ou une couche isolante épaisse et massive, par exemple de carbure de silicium.

La référence 20 désigne un deuxième substrat de silicium, de type monocristallin présentant une couche mince superficielle 22 séparée du reste du substrat par une zone 24 de clivage préférentiel.

La zone de clivage 24, comme évoqué précédemment peut être formée par l'implantation d'ions hydrogène à une profondeur donnée dans le substrat.

La couche superficielle 22 peut contenir des impuretés ou d'autres défauts constituant des centres de recombinaison radiative de porteurs. Ces caractéristiques n'apparaissent pas sur la figure 1, mais seront décrits plus en détail dans la suite du texte.

Le deuxième substrat 20 est reporté sur le support 10 en collant la surface libre de la couche superficielle sur la première couche d'oxyde de silicium 12.

Le collage est effectué sans ajout de matériau liant, mais par liaison moléculaire entre les parties mises en contact.

Selon une variante, la première couche d'oxyde peut également être formée initialement sur la couche mince superficielle de silicium du deuxième substrat.

Dans ce cas, le collage moléculaire a lieu entre cette couche et le support 10.

La figure 2 montre la structure obtenue après le collage de la couche mince de silicium, le clivage selon la zone de clivage et l'élimination de la partie restante du deuxième substrat.

Selon une variante, la zone de clivage 24, visible à la figure 1 peut être remplacée par une couche sacrificielle. La structure de la figure 2 est alors obtenue par collage puis par dissolution sélective de la couche sacrificielle.

On remarque également sur la figure 2 une deuxième couche d'oxyde de silicium 32, qui recouvre la couche mince de silicium 22. La deuxième couche d'oxyde 32 peut être formée, par exemple, par dépôt ou par oxydation en surface de la couche de silicium.

On peut observer, que selon un autre procédé de fabrication, la première couche d'oxyde de silicium peut être également formée par implantation d'ions oxygène dans un bloc de silicium avec une énergie suffisante pour l'enterrer sous la couche superficielle 22.

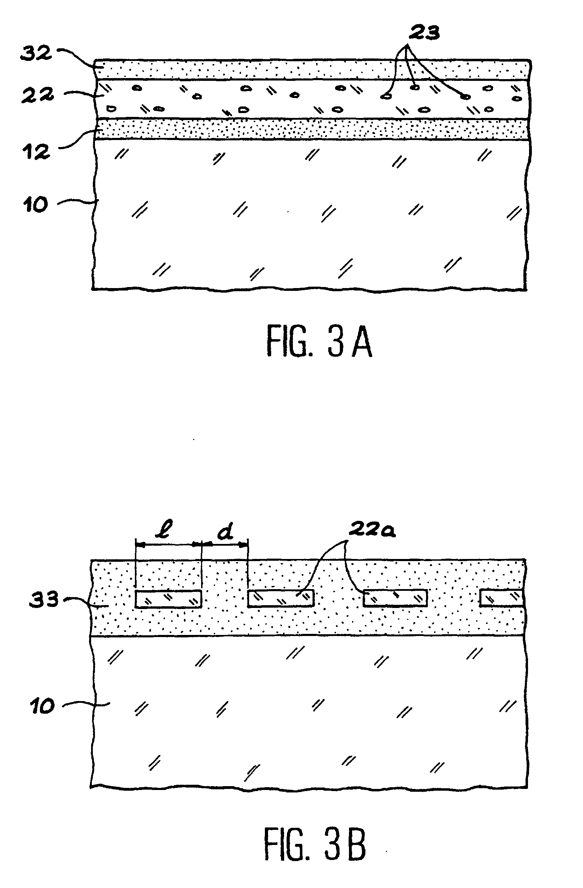

Les figures 3A, 3B, 4 et 5 décrites ci-après, correspondent à la structure de la figure 2 et montrent différents types de centres radiatifs pouvant être prévus dans la couche de silicium 22 et différentes configurations de la couche de silicium. Ces différentes possibilités doivent être comprises comme n'étant pas exclusives les unes des autres.

Dans l'exemple de la figure 3A, les centres radiatifs sont formés par des impuretés 23, telles que des ions de terres rares, réparties dans la couche mince de silicium.

Ces impuretés peuvent être mises en place par implantation ionique. Elles peuvent être introduites à différents stades de la fabrication de la structure, par exemple par implantation dans le substrat 20 avant collage moléculaire ou bien par implantation dans la couche mince 22 après collage.

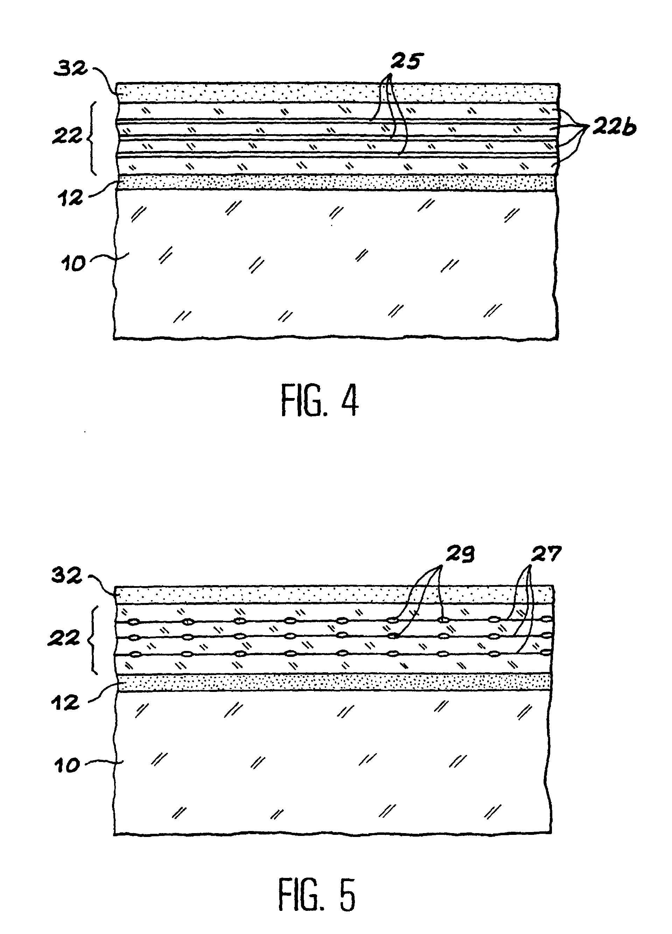

La figure 3B montre une réalisation particulière dans laquelle, au moyen d'une oxydation traversant la couche de silicium, on a formé une pluralité d'îlots discontinus 22a formant chacun une région active. Chacune de ces régions actives peut contenir des impuretés ou d'autres centres radiatifs, de la même façon que la couche 22 de silicium de la figure 3. Les centre radiatifs du dispositif, de la figure 4, ne sont pas représentés pour des raisons de clarté.

Sur la figure 3B, on désigne par "$\ell$" la longueur des îlots parallèlement à la surface du support 10 et par "d" la distance entre îlots. La longueur "$\ell$" est de préférence du même ordre que l'épaisseur des îlots. Cette longueur est de 100 nm à 200 nm, par exemple, de même que l'épaisseur des îlots.

La figure 4 montre une variante dans laquelle les centres radiatifs sont formés par des puits quantiques.

Les puits quantiques sont formés par des fines couches 25 de germanium ou d'alliage $Si_{1-x}Ge_x$ ($0<x\leq1$) ou SiGeC ou tout autre matériau adapté à la formation de puits quantiques, intercalées dans la couche de silicium. Les couches 25 forment les puits quantiques et présentent une épaisseur suffisamment faible, par exemple de l'ordre de 5 nm, de sorte que l'épaisseur cumulée de ces couches ne provoque pas de dislocations du silicium, résultant d'un désaccord de maille. A titre d'exemple, la structure peut comporter cinq couches de puits quantiques en $Si_{1-x}Ge_x$ avec x=0,2.

Les couches 25 de puits quantiques sont séparées par des barrières minces formées par des sous-couches 22b de la couche de silicium 22.

La couche de silicium 22, qui forme la région active, peut être formée par épitaxie en alternant successivement les sous-couches 22a de silicium et les sous-couches formant les puits quantiques 25.

La figure 5 montre encore une autre possibilité dans laquelle les centres radiatifs sont des boîtes quantiques 29.

Les boîtes quantiques 29 sont obtenues en introduisant dans la couche de silicium 22 des couches de germanium 27 dont l'épaisseur est de l'ordre de quelques couches monoatomiques. Ces couches sont trop fines pour introduire des dislocations dans le silicium.

Toutefois, en raison d'un désaccord de maille entre le silicium et le germanium, il se forme naturellement des îlots de germanium 29 qui constituent les boîtes quantiques.

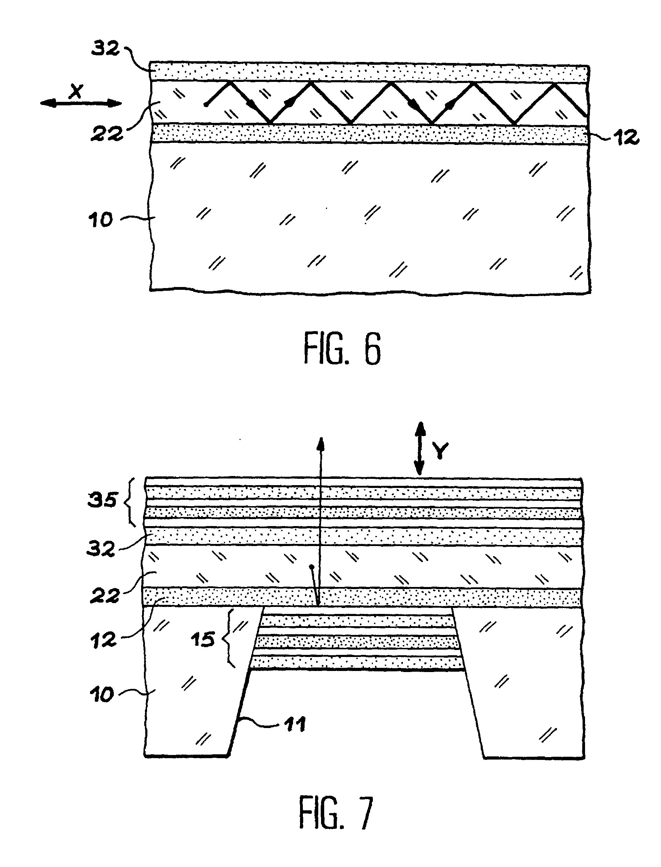

La figure 6 montre une première possibilité de réalisation des moyens de confinement des porteurs et de guidage de la lumière qui mettent à profit un saut d'indice entre la couche de silicium 22 et les première et deuxième couches d'oxyde de silicium 12 et 32.

Dans cette réalisation, l'épaisseur optique e de la région active, c'est-à-dire de la couche 22 est adaptée de façon à vérifier la formule $e = \frac{k}{2} \cdot \lambda$ où $\lambda$ est la longueur d'onde de travail du dispositif, k un entier.

La propagation de la lumière a lieu par réflexion totale sur les couches d'oxyde de silicium, de sorte que le guidage de la lumière s'effectue selon un plan principal de la région active, parallèle aux première et deuxième couches d'oxyde, et indiqué avec une double flèche X.

La figure 7 montre une deuxième possibilité de réalisation des moyens de guidage de la lumière.

Les moyens de guidage comportent un premier miroir 15 formé sur une face libre de la première couche d'oxyde 12, et situé dans une ouverture 11 pratiquée par gravure dans le premier substrat 10.

Un deuxième miroir 35 des moyens de guidage est formé sur la surface libre de la deuxième couche d'oxyde 32.

On entend par faces libres des couches d'oxyde les faces qui ne sont pas en contact avec la région active.

Les miroirs 15 et 35 sont formés, par exemple, par une alternance de couches de matériaux diélectriques à la manière d'un miroir de Bragg. Les paires de couches sont, par exemple, du type $ZnS/YF_3$ ou $SiO_2/Si_3N_4$.

De préférence, la couche de silicium 22 et les première et deuxième couches d'oxyde de silicium 12, 32 sont choisies de façon à former une cavité de type Fabry-Pérot.

Avec le dispositif de la figure 7, la propagation de la lumière est sensiblement perpendiculaire au plan principal de la région active, c'est-à-dire perpendiculaire aux miroirs.

La direction de propagation est indiquée par une double flèche Y.

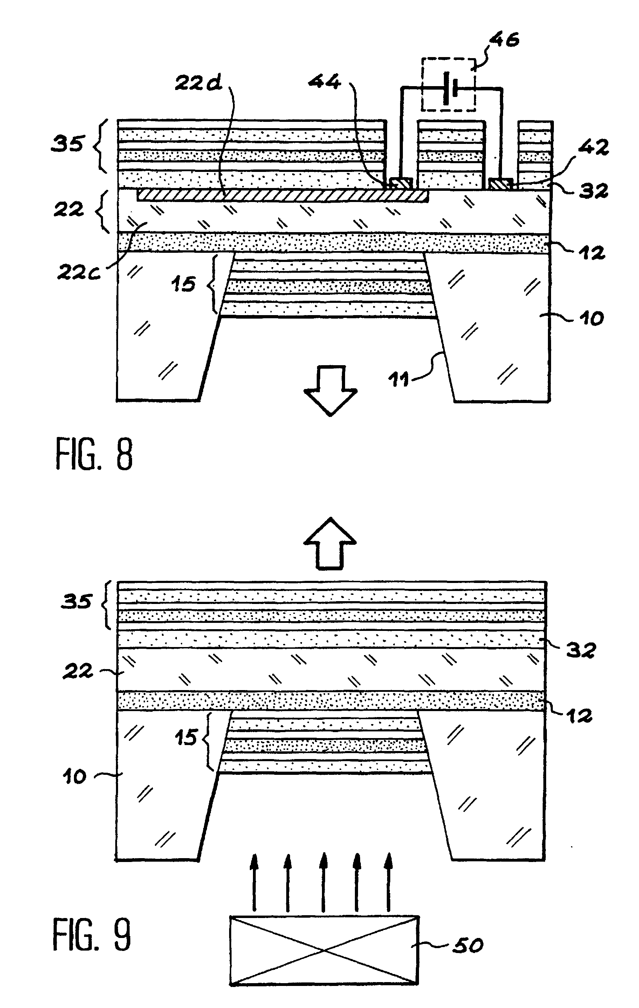

Les figures 8 et 9 montrent des réalisations particulières de moyens de pompage utilisés dans des dispositifs dont la structure est sensiblement celle illustrée par la figure 7. Il convient cependant de noter que les moyens de pompage peuvent être adaptés aux autres formes possibles du dispositif, et décrites précédemment.

Dans le dispositif de la figure 8, la couche 22 de silicium, formant la région active, comporte une première partie 22c présentant un premier type de conductivité et une deuxième partie 22d présentant un type de conductivité opposé à celui de la première partie, de façon à créer dans la région active une jonction de diode. La deuxième partie 22d peut être formée par implantation d'ions dans la première partie 22c de la couche de silicium.

Des contacts 42, 44 formés respectivement sur les première et deuxième parties 22c, 22d de la couche de silicium, sont connectés à une source de tension 46, pour polariser la jonction et provoquer un passage de courant s'accompagnant de la recombinaison radiative d'électrons et de trous.

Les contacts 42 et 44 sont réalisés dans des ouvertures pratiquées dans le deuxième miroir 35.

Le deuxième miroir 35 présente, dans cet exemple de réalisation, un coefficient de transmission de la lumière inférieur à 1%, tandis que le premier miroir 15 présente un coefficient de transmission permettant l'extraction de lumière, de l'ordre de 40%.

Ainsi, la lumière est extraite à travers le premier miroir 15 et à travers l'ouverture 11 du support 10. Une flèche indique l'extraction de lumière.

La figure 9 montre un dispositif dans lequel le rôle des miroirs est inversé.

Le premier miroir 15 présente un coefficient de transmission très faible de la lumière à la longueur d'onde de travail, tandis que le second miroir 35 laisse sortir (en partie) la lumière provenant de la région active.

Contrairement au dispositif de la figure 8, le dispositif de la figure 9 est pompé optiquement à partir d'une source de lumière de pompage 50.

La source de lumière de pompage peut être un laser, pulsé ou non qui doit être absorbé de façon efficace dans la couche active 22. Dans ce but, on préfère un laser à courte longueur d'onde. La longueur d'onde de la lumière de pompage est choisie différente de la longueur d'onde de travail de la lumière de la région active.

Le premier miroir 15 recevant la lumière de pompage est accordé pour être transparent à la longueur d'onde de cette lumière, et résonnant à la longueur d'onde de travail du dispositif.

**DOCUMENTS CITES**

*(1)*

EP-A-0 517 440

*(2)*

GB-A-2 275 582

*(3)*

"Giant enhancement of luminescence intensity in Erdoped Si/SiO$_2$ resonant cavities"
Appl. Phys. Lett. 61(12), 21 Sept. 1992 de E. F. Schubert et al.

*(4)*

"Silicon intersubband lasers"
Superlattices and Microstructures, vol. 23, n° 2, 1998
de Richard A. Soref.

*(5)*

"Prospects for novel Si-based optoelectronic devices : unipolar and p-i-p-i lasers"
Thin Solid Films 294 (1997) 325-329
de Richard A. Soref

*(6)*

"Characterization of bond and etch-back silicon-on-insulator wafers by photoluminescence under ultraviolet excitation"
Appl. Phys. Lett. 70(2), 13 January 1977
de M. Tajima et al.

*(7)*

"Luminescence due to electron-hole condensation in silicon-on-insulator"
Journal of Applied Physics, volume. 84, n° 4, 15 August 1998
de Michio Tajima et al.

*(8)*

WO 96 25767-A-

*(9)*

REITTINGER A et al. : "INFLUENCE OF THE ERBIUM AND OXYGEN CONTENT ON THE ELECTROLUMINESCENCE OF EPITAXIALLY GROWN ERBIUM-DOPED SILICON DIODES" APPLIED PHYSICS LETTERS, Vol. 70, n° 18, 5 mai 1997 (1997-05-05), pages 2431-2433.

**Revendications**

1. Dispositif émetteur et guide de lumière comprenant au moins une région active (22) en silicium, le silicium de la région active étant monocristallin et des moyens pour créer des photons dans ladite région active, **caractérisé en ce que** les moyens pour créer les photons comportent une diode (22c, 22d) formée dans la région active, **en ce que** le dispositif comporte des moyens de confinement avec des première et deuxième couches d'isolant (12, 32) pour confiner des porteurs injectés par la diode.

2. Dispositif selon la revendication 2, pour la propagation d'une lumière de longueur d'onde donnée λ, dans lequel la région active présente une épaisseur optique e telle que :

$$e = k \frac{\lambda}{2}$$

où k est un entier naturel.

3. Dispositif selon la revendication 1, dans lequel les première et deuxième couches d'isolant sont des couches d'oxyde de silicium.

4. Dispositif selon la revendication 1, comportant en outre des moyens de réflexion de la lumière comportant au moins un miroir (15, 35) disposé sur une face libre d'au moins l'une des première et deuxième couches d'isolant.

5. Dispositif selon la revendication 4, dans lequel les moyens de réflexion de la lumière comportent un premier miroir (15) disposé sur la face libre de la première couche d'isolant (12) et un deuxième miroir (35) disposé sur la face libre de la deuxième couche d'isolant (32), les premier et deuxième miroirs présentant des coefficients de transmission différents.

6. Dispositif selon la revendication 5, dans lequel les premier et deuxième miroirs forment avec la région active et les couches isolantes une cavité de type Fabry-Pérot.

7. Dispositif selon la revendication 4, dans lequel au moins un miroir (15, 35) comporte un empilement de couches diélectriques.

8. Dispositif selon la revendication 1, dans lequel les moyens pour créer des photons dans la région active comportent en outre une source additionnelle de lumière (50).

9. Dispositif selon la revendication 1, dans lequel la région active comprend des centres radiatifs.

10. Dispositif selon la revendication 9, dans lequel les centres radiatifs sont en un matériau choisi parmi le Si, le Ge, le SiGe, le SiGeC.

11. Dispositif selon la revendication 9, dans lequel les centres radiatifs comportent des impuretés (23) de terres rares dans la région active.

12. Dispositif selon la revendication 9, dans lequel les centres radiatifs comportent au moins un puits quantique dans la région active.

13. Dispositif selon la revendication 9, dans lequel les centres radiatifs comportent des boîtes quantiques (29) réparties dans la région active.

14. Dispositif selon la revendication 1, comportant une pluralité de régions actives (22a) entre les première et deuxième couches isolantes et séparées entre elles par un matériau isolant.

15. Dispositif selon la revendication 14, dans lequel les régions actives (22a) sont des îlots de entourés de matériau isolant, les îlots présentant une dimension caractéristique (ℓ) sensiblement égale à leur épaisseur.

16. Procédé de fabrication d'un dispositif selon la revendication 1, **caractérisé en ce qu'**il comporte le report d'une couche mince de silicium destinée à former la région active sur un support par collage moléculaire, puis le recouvrement de ladite couche de silicium par une couche d'isolant.

17. Procédé selon la revendication 16, dans lequel le report de la couche mince comporte :

   - le collage moléculaire sur le support d'un bloc de silicium (20) épais par une face de report, le bloc étant pourvu d'une zone de clivage préférentiel (24) parallèle à la face de report et délimitant la couche mince (22),
   - puis après le collage, le clivage dudit bloc pour en séparer la couche mince.

18. Procédé selon la revendication 16, dans lequel le report de la couche mince comprend le collage sur le support d'une couche de silicium solidaire d'un substrat de silicium par l'intermédiaire d'une couche sacrificielle, puis la séparation de la couche mince du substrat par dissolution de la couche sacrificielle.

19. Procédé de fabrication d'un dispositif selon la revendication 3, comprenant la formation d'une première couche d'oxyde enterrée (12) dans un bloc de silicium de façon à délimiter une couche mince superficielle de silicium (22) dans le bloc, la couche mince superficielle étant destinée à former la région active, puis le recouvrement de la couche mince par une deuxième couche d'oxyde.

**Patentansprüche**

1. Lichtemittierende und -leitende Vorrichtung mit wenigstens einem aktiven Bereich (22) aus Silicium, wobei das Silicium dieses aktiven Bereichs monokristallin ist, und Einrichtungen zum Erzeugen von Photonen in diesem aktiven Bereich, **dadurch gekennzeichnet, dass** die Einrichtungen zur Photonenerzeugung eine Diode (22c, 22d) umfassen, ausgebildet in dem aktiven Bereich, und **dadurch, dass** die Vorrichtung Einschließeinrichtungen mit einer ersten und einer zweiten Isolierschicht (12, 32) umfasst, um in die Diode injizierte Träger einzuschließen.

2. Vorrichtung nach Anspruch 1 zur Ausbreitung eines Lichts einer bestimmten Wellenlänge λ, bei der der aktive Bereich eine optische Dicke e wie folgt aufweist:

$$e = k\frac{\lambda}{2}$$

wo k eine natürliche Zahl ist.

3. Vorrichtung nach Anspruch 1, bei der die erste und die zweite Isolierschicht Siliciumdioxidschichten sind.

4. Vorrichtung nach Anspruch 1, die außerdem Reflexionseinrichtungen des Lichts enthalten, die wenigstens einen Spiegel (15, 35) umfassen, angeordnet auf einer freien Seite von wenigstens einer der genannten beiden Isolierschichten (12, 32).

5. Vorrichtung nach Anspruch 4, bei der die Reflexionseiririchtunge des Lichts einen ersten, auf der freien Seite der ersten Isolierschicht (12) angebrachten Spiegel (15) und einen zweiten, auf der freien Seite der zweiten Isolierschicht (32) angebrachten Spiegel (35) umfassen, wobei der erste und der zweite Spiegel unterschiedliche Transmissionskoeffizienten haben.

6. Vorrichtung nach Anspruch 5, bei der der erste und der zweite Spiegel zusammen mit dem aktiven Bereich und den Isolierschichten einen Resonator des Fabry-Perot-Typs bilden.

7. Vorrichtung nach Anspruch 4, bei der wenigstens ein Spiegel (15, 35) einen Stapel dielektrischer Schichten umfasst.

8. Vorrichtung nach Anspruch 1, bei der die Einrichtungen zur Photonenerzeugung in dem aktiven Bereich außerdem eine zusätzliche Lichtquelle (50) umfassen.

9. Vorrichtung nach Anspruch 1, bei der der aktive Bereich radiative Zentren umfasst.

10. Vorrichtung nach Anspruch 9, bei der die radiativen Zentren aus einem Material sind, das ausgewählt wird unter Si, Ge, SiGe, SiGeC.

11. Vorrichtung nach Anspruch 9, bei der die radiativen Zentren in dem aktiven Bereich Seltenerden-Verunreinigungen (23) umfassen.

12. Vorrichtung nach Anspruch 9, bei der die radiativen Zentren in dem aktiven Bereich wenigstens einen Quantenschacht umfassen.

13. Vorrichtung nach Anspruch 9, bei der die radiativen Zentren Quantenpunkte (29) umfassen, verteilt in dem aktiven Bereich.

14. Vorrichtung nach Anspruch 1, zwischen der ersten und der zweiten Isolierschicht eine Vielzahl aktiver Bereiche (22a) umfassend, voneinander getrennt durch ein isolierendes Material.

15. Vorrichtung nach Anspruch 14, bei der die aktiven Bereiche (22a) Inseln sind, umgeben von isolierendem Material, wobei die Inseln eine charakteristische Dimension ($\ell$) haben, die im Wesentlichen ihrer Dicke entspricht.

16. Verfahren zur Herstellung einer Vorrichtung nach Anspruch 1, **dadurch gekennzeichnet, dass** es die Übertragung einer den aktiven Bereich bildenden Silicium-Dünnschicht durch molekulare Klebung auf einen Träger und dann das Überziehen der genannten Siliciumschicht mit einer Isolierschicht umfasst.

17. Verfahren nach Anspruch 16, bei dem die Übertragung der Dünnschicht umfasst:

    - die molekulare Klebung eines dicken Siliciumblocks (20) mit einer Übertragungsseite auf den Träger, wobei der Block eine bevorzugte Spaltungszone (24) hat, parallel zu der Übertragungsseite, die Dünnschicht (22) abgrenzend,
    - dann, nach der Klebung, das Spalten des genannten Blocks, um die Dünnschicht abzutrennen.

18. Verfahren nach Anspruch 16, bei dem die Übertragung der Dünnschicht die Klebung einer Siliciumschicht, die mittels einer Opferschicht mit einem Siliciumsubstrat verbunden ist, auf den Träger umfasst, und dann, durch Auflösung der Opferschicht, die Abtrennung der Dünnschicht von dem Substrat.

19. Verfahren zur Herstellung einer Vorrichtung nach Anspruch 3, die Bildung einer ersten, in einem Siliciumblock vergrabenem Oxidschicht (12) umfassend, um in dem Block eine Oberflächen-Dünnschicht (22) abzugrenzen, wobei die Oberflächendünnschicht dazu bestimmt ist, den aktiven Bereich zu bilden, und dann das Überziehen der Dünnschicht mit einer zweiten Oxidschicht.

**Claims**

1. Light emitting and guiding device comprising at least one active region (22) in silicon, the silicon of the active region being monocrystalline, and the means for creating photons in the said active region, **characterized in that** the means for creating the photons comprises a diode (22c, 22d) formed in the active region and **in that** the device comprises means of confinement with first and second insulating layers (12, 32) for confining carriers injected by the diode.

2. Device according to claim 1, for the propagation of light with a given wavelength λ, in which the assembly comprising the active region and the insulating layers has an optical thickness e, such that:

$$e = k\,\frac{\lambda}{2}$$

   where k is a natural number.

3. Device according to claim 1, in which the first and second insulating layers are layers of silicon oxide.

4. Device according to claim 1, comprising an addition to the means of reflecting light, comprising at least one mirror (15, 35) arranged on a free face of at least one of the first and second insulating layers.

5. Device according to claim 4, in which the means for reflecting the light comprise a first mirror (15) arranged on the free face of the first insulating layer (12) and a second mirror (35) arranged on the free face of the second insulating layer (32), the first and second mirrors having different transmission coefficients.

6. Device according to claim 5, in which the first and second mirrors form, with the active region and the insulating layers, a Fabry-Pérot type cavity.

7. Device according to claim 4, in which at least one mirror (15, 35) comprises a stack of dielectric layers.

8. Device according to claim 1, in which the means for creating photons in the active region comprise, moreover, an additional source of light (50).

9. Device according to claim 1, in which the active region comprises radiative centres.

10. Device according to claim 9, in which the radiative centres are in a material chosen from Si, Ge, Site and SiGeC.

11. Device according to claim 9, in which the radiative centres comprise rare earth element impurities (23) in the active region.

**12.** Device according to claim 9, in which the radiative centres comprise at least one quantum well in the active region.

**13.** Device according to claim 9, in which the radiative centres comprise quantum boxes (29) spread out over the active region.

**14.** Device according to claim 1, comprising a plurality of active regions (22a) between the first and second insulating layers and separated from each other by an insulating material.

**15.** Device according to claim 14, in which the active regions (22a) are islands surrounded by insulating material, the islands having a characteristic size (1) more or less equal to their thickness.

**16.** Process for manufacturing a device according to claim 1, **characterized in that** it comprises the transfer of a thin layer of silicon **that** is intended to form the active region onto a support by molecular bonding, then covering the said layer of silicon by an insulating layer.

**17.** Process according to claim 16, in which the transfer of the thin layer comprises:

- the molecular bonding on the support of a block of thick silicon (20) by a transfer face, the block being provided with a preferential cleavage zone (24) parallel to the transfer face and which delimits the thin layer (22),
- then, after the bonding, the said block is cleaved to separate the thin layer from it.

**18.** Process according to claim 16, in which the transfer of the thin layer comprises the bonding, onto the support, of a layer of silicon connected to a silicon substrate via a sacrificial layer, then the separation of the thin layer from the substrate by dissolving the sacrificial layer.

**19.** Process for manufacturing a device according to claim 3, comprising the formation of a first layer of oxide (12) buried in a block of silicon in such a way as to delimit a thin superficial layer of silicon (22) in the block, the thin superficial layer being intended to form the active region, and then covering the thin layer by a second layer of oxide.

20

24

22

12

10

FIG.1

32

22

12

10

FIG. 2

FIG. 3 A

FIG. 3 B

FIG. 4

FIG. 5

FIG. 6

FIG. 7

**FIG. 8**

**FIG. 9**